# EUROPÄISCHE PATENTSCHRIFT

(11) **EP 3 519 127 B1**
(45) Veröffentlichungstag und Bekanntmachung des Hinweises auf die Patenterteilung: **15.03.2023**
(21) Anmeldenummer: 17783756.4
(22) Anmeldetag: 25.09.2017
(51) Int. Cl.: B22F 3/105, H01L 23/473, H05K 7/20, H01L 23/373, H01L 23/12, H01L 23/36, H01S 5/40, H05K 3/00, H01L 33/64, H01S 5/024, B22F 5/10, B29C 64/153, H01L 21/48, H01S 5/0237, B33Y 10/00, B29C 64/188, C22C 26/00, B33Y 80/00, B22F 7/08

(54) **OPTISCHE ODER OPTOELEKTRONISCHE BAUGRUPPE UND HERSTELLUNGSVERFAHREN EINER SOLCHEN**
OPTICAL AND OPTOELECTRONIC ASSEMBLY AND METHOD FOR THE PRODUCTION THEREOF
ENSEMBLE DE COMPOSANTS OPTIQUES OU OPTO-ÉLECTRONIQUES ET MÉTHODE DE FABRICATION DE CELUI-CI

(30) Priorität: 27.09.2016 DE 102016218522
(43) Veröffentlichungstag der Anmeldung: 07.08.2019
(73) Patentinhaber: JENOPTIK Optical Systems GmbH, 07745 Jena (DE)
(72) Erfinder: WOLF, Jürgen, 07646 Schlöben (DE); HIRSCH, Annelies, 07743 Jena (DE)
(74) Vertreter: Waldauf, Alexander
(86) Internationale Anmeldenummer: PCT/EP2017/074223
(87) Internationale Veröffentlichungsnummer: WO 2018/060134

(56) Entgegenhaltungen:
- JP-A- 2004 186 212
- US-A- 5 105 429
- US-A1- 2005 168 950
- US-A1- 2006 067 373
- US-A1- 2010 314 072
- HARNAGEL G L ET AL: "LARGE LASER DIODE ARRAYS FOR HIGH-DUTY-CYCLE OPERATION", ELECTRONICS LETTERS, IEE STEVENAGE, GB, Bd. 28, Nr. 18, 27. August 1992 (1992-08-27), Seiten 1702-1704, XP000309469, ISSN: 0013-5194

## Beschreibung

### Technisches Gebiet

Die Erfindung betrifft die Herstellung einer optischen oder optoelektronischen Baugruppe unter Verwendung eines 3D- Druckverfahrens. Die Baugruppe umfasst ein optisches oder optoelektronisches Bauteil, welches im Betrieb gekühlt werden soll, und einen Kühler.

### Stand der Technik

Aus EP1672690A1 ist ein Mikrokanalkühler für einen Laserbarren bekannt, sowie die Herstellung desselben durch selektives Laserschmelzen eines Metallpulvers. Nachteilig ist, dass die Montagefläche für das Bauteil in elektrischem Kontakt mit dem Kühlkörper steht. Wenn eine elektrische Isolation des Bauteils vom Kühlkörper erforderlich ist, muß eine isolierende Zwischenschicht vorgesehen werden, die den Nachteil hat, dass der Wärmeübergang infolge zusätzlicher Grenzschichten schlechter ist. Aus WO 2009/062732A2 ist die Herstellung ähnlicher Mikrokanalkühler unter kombinierter Verwendung verschiedener Metallpulver bekannt.

Aus WO 2011/040044A1 ist bekannt, einen Kühler derart herzustellen, dass eine gesinterte Metallfolie auf eine andere metallische Schicht aufgewalzt wird und dadurch ein Laminatkörper aufgebaut wird.

Aus DE 195 06 091A1 ist die Herstellung eines Kühlelements für elektrische Schaltkreise durch Stapeln flächig miteinander verbundener Schichten bekannt. Nachteilig ist, dass Einschränkungen bei der konstruktiven Gestaltung der Kühler bestehen und die aufwendige Herstellung der Kühler. Schichtweise aufgebaute Kühler für Laserbarren mit den gleichen Nachteilen sind auch aus DE4315580A1 bekannt.

Aus WO96/013350 A1 ist bekannt, einen Kühler herzustellen, indem Metallpulver mit einem organischen Bindemittel versehen, der Kühler in Form gepresst und hernach das Bindemittel verdampft und die Pulverpartikel verbunden werden. Nachteilig ist, dass der Kühler eine Leckrate aufweisen kann, sowie die fehlende elektrische Isolierung.

Aus DE 199 39 774 A1 ist bekannt, eine Laserscheibe rückseitig direkt mit einem Kühlmittelstrahl zu kühlen. Dabei kann die Laserscheibe naß werden und außerdem kann der Kühlmittelstrahl abrasiv wirken, was die Lebensdauer beeinträchtigen kann.

Aus DE102014201306A1 ist ein Herstellungsverfahren für ein Leistungselektronikmodul bekannt, bei dem eine Kühlerstruktur auf ein Leistungselektronikbauteil aufgetragen wird. Nachteilig ist, dass das Leistungselektronikbauteil den Belastungen beim Herstellungsprozess der Kühlerstruktur ausgesetzt wird.

Aus DE102015007791A1 ist das Herstellen eines Kühlkörpers mittels eines generativen Fertigungsverfahrens bekannt geworden. In dieser Veröffentlichung wird vorgeschlagen, den Kühlkörper auszubilden, indem die Laserquelle in ein Metallpulverbett gesetzt und das Metallpulver unter Zuhilfenahme eines Anlagenlasers mit einer auf der Laserquelle befindlichen Metallschicht verbunden wird. Nachteilig ist, dass die Gefahr besteht, dass die Laserquelle dabei beschädigt wird.

Weiterer Stand der Technik wird in den Dokumenten US2006/0067373-A1, US2010/0314072-A1 und GB2419463-A aufgezeigt.

### Aufgabe der Erfindung

Aufgabe der Erfindung ist es, ein einfaches und kostengünstiges Herstellungsverfahren für eine optische oder optoelektronische Baugruppe anzugeben. Die Baugruppe soll eine möglichst gute Kühlung des optischen oder optoelektronischen Bauteils gewährleisten. Das optische bzw. optoelektronische Bauteil ist dabei vor starken thermischen und mechanischen Belastungen zu schützen. Eine weitere Aufgabe ist es, eine optische oder elektrooptische Baugruppe anzugeben, bei welcher ein optisches oder elektrooptisches Bauteil besonders effizient gekühlt werden kann.

### Vorteile der Erfindung

Das erfindungsgemäße Verfahren erlaubt die kostengünstige Herstellung einer optischen oder optoelektronischen Baugruppe. Die fertige Baugruppe hat zahlreiche Vorteile. Das zu kühlende Bauteil kann von der Kühlerstruktur elektrisch isoliert montiert werden. Dadurch kann das Kühlmittel vom zu kühlenden Bauteil elektrisch isoliert sein, ohne dass zusätzliche Isolationsschichten erforderlich sind. Die Anzahl von Grenzschichten, die den Wärmedurchgang beeinträchtigen, ist minimiert. Eine Vielzahl von Baugruppen kann im Nutzen parallel gefertigt werden. Bei der Ausführung mit einem solchen Laserbauteil, welches mehrere Laserbarren umfasst, ist besonders vorteilhaft, dass die einzelnen Laserbarren gegeneinander isoliert werden können, ohne dass zusätzliche Isolationsschichten verwendet werden müssen. Die Herstellung des Kühlkörpers kann bei einer hohen Temperatur erfolgen, dadurch verläuft der Prozeß schnell.

### Lösung der Aufgabe:

Die Aufgabe wird gelöst durch Verfahren zur Herstellung einer optischen oder optoelektronischen Baugruppe, umfassend
a) Bereitstellen einer Verbundplatte, wobei die Verbundplatte wenigstens eine erste nichtmetallische Lage und eine erste metallische Lage und eine zweite metallische Lage aufweist
b) Untergliedern der zweiten metallischen Lage in mehrere zweite Bereiche
c) Bereitstellen einer Startfläche auf der ersten metallischen Lage,
d) Herstellung einer Kühlerstruktur auf der Startfläche durch selektives Schmelzen und/oder durch selektives Sintern wenigstens eines ersten Materials,
e) Bereitstellen eines optischen oder optoelektronischen Bauteils, wobei das Bauteil wenigstens eine optisch gepumpte Laserscheibe oder wenigstens einen Diodenlaserbarren oder wenigstens eine Lichtemitterdiode (LED) umfasst
f) Befestigen des Bauteils auf einer Montagefläche, welche auf der zweiten metallischen Lage angeordnet ist, wobei das Befestigen des Bauteils nach der Herstellung der Kühlerstruktur erfolgt und das Bauteil mehrere zweite Bereiche der zweiten metallischen Lage überdeckt.

Die Aufgabe wird gelöst durch eine optische oder optoelektronische Baugruppe umfassend einen Kühler und ein optisches oder optoelektronisches Bauteil, wobei der Kühler umfasst
a) eine Verbundplatte, wobei die Verbundplatte wenigstens eine erste nichtmetallische Lage und eine erste metallische Lage und eine zweite metallische Lage aufweist, wobei die zweite metallische Lage in mehrere zweite Bereiche gegliedert ist,
   wobei die Verbundplatte eine Startfläche auf der ersten metallischen Lage aufweist,
b) eine auf der Startfläche mit einem 3D Druckverfahren hergestellte Kühlerstruktur aus einem ersten Material, welches ein Metall umfasst,
c) eine Montagefläche für das Bauteil, welche auf der zweiten metallischen Lage angeordnet ist wobei das Bauteil auf der Montagefläche befestigt ist und das Bauteil mehrere zweite Bereiche der zweiten metallischen Lage überdeckt.

### Detaillierte Beschreibung

Die Erfindung beinhaltet ein Verfahren zur Herstellung einer optischen oder optoelektronischen Baugruppe. Unter einer optischen Baugruppe kann eine Baugruppe verstanden werden, die ein aktives optisches Bauteil umfasst. Ein aktives optisches Bauteil kann ein solches Bauteil sein, welches dazu vorgesehen ist, im Betrieb eine sekundäre Lichtstrahlung zu emittieren und dabei Energie in Form einer primären Lichtstrahlung aufzunehmen. Die primäre und/oder die sekundäre Lichtstrahlung können Laserlicht sein. Die primäre Lichtstrahlung kann als Pumplicht bezeichnet werden. Das aktive optische Bauteil kann also optisch gepumpt sein. Ein solches Bauteil kann im Betrieb Abwärme entwickeln. Deshalb kann die Notwendigkeit bestehen, dieses zu kühlen. Ein optisches Bauteil kann ein optisches Verstärkerelement sein, beispielsweise eine Laserkristallscheibe oder eine Halbleiterlaserscheibe, die zu optisch gepumpten Betrieb vorgesehen ist. Unter einer optoelektronischen Baugruppe kann eine Baugruppe verstanden werden, die ein aktives optoelektronisches Bauteil umfasst, welches im Betrieb Abwärme entwickeln kann und deshalb die Notwendigkeit bestehen kann, dieses zu kühlen. Ein optoelektronisches Bauteil kann ein Element umfassen, das basierend auf einem Halbleitermaterial elektrische Energie in eine Lichtstrahlung umwandelt, beispielsweise eine Lichtemitterdiode (LED) oder eine Laserdiode. Anders ausgedrückt, kann das optoelektronische Bauteil ein solches sein, welches im Betrieb eine (sekundäre) Lichtstrahlung emittiert und dazu elektrisch gepumpt wird. Diese Lichtstrahlung kann durch spontane Emission entstehen, in diesem Fall kann man das optoelektronische Bauteil als LED Bauteil bezeichnen. Die Lichtstrahlung kann alternativ durch stimulierte Emission entstehen, dann kann man das optoelektronische Bauteil als Laserbauteil bezeichnen. Das optoelektronische Bauteil kann auch mehrere optoelektronische Elemente umfassen.

Um das Verfahren auszuführen, ist eine Verbundplatte bereitzustellen. Die Verbundplatte ist mehrlagig ausgeführt, wobei die Verbundplatte wenigstens eine erste nichtmetallische Lage und eine erste metallische Lage und eine zweite metallische Lage aufweist. Darüber hinaus kann die Verbundplatte weitere nichtmetallische Lagen und/oder weitere metallische Lagen umfassen. Jedoch kann die Verwendung einer Verbundplatte, welche nur eine einzige nichtmetallische Lage umfasst, besonders vorteilhaft sein. Die erste metallische Lage und die zweite metallische Lage können auf den gegenüberliegenden Seiten der ersten nichtmetallischen Lage angeordnet sein. Dadurch kann die zweite metallische Lage von der ersten metallischen Lage elektrisch isoliert sein. Vorteilhaft ist jeweils eine feste flächige Verbindung der ersten metallischen Lage sowie der zweiten metallischen Lage mit der ersten nichtmetallischen Lage. Dadurch kann der Wärmeübergang zwischen den Lagen hergestellt werden. Die Verbundplatte kann beispielsweise eine Keramikplatte umfassen, die auf beiden Seiten je eine metallische Lage aufweist. Eine solche Platte kann durch Aufbringen jeweils einer metallischen Schicht auf jeder der beiden Seiten einer keramischen Grundplatte hergestellt werden. Solche Schichten können in bekannter Weise galvanisch hergestellt werden oder mit dem bekannten DCB (direct copper bonding)- Verfahren hergestellt werden. Als Verbundplatte kann beispielsweise eine handelsübliche DCB Platte (DCB Substrat) verwendet werden. Eine DCB-Platte kann als erste nichtmetallische Lage beispielsweise eine keramische Trägerplatte mit einer Dicke zwischen 0,25mm und 2mm umfassen. Diese kann beispielsweise aus Al₂O₃, AIN oder SiC bestehen Die Verbundplatte kann auf beiden Seite jeweils eine metallische Lage umfassen, die jeweils als metallische Schicht, beispielsweise als Cu- oder Ag- Schicht mit einer Dicke zwischen 0,025mm und 0,5mm ausgebildet sein kann. Ohne Beschränkung der Allgemeinheit kann im Folgenden ein orthogonales Koordinatensystem xyz gewählt werden, bei welchem die Verbundplatte in einer xz Ebene liegt.Beim erfindungsgemäßen Verfahren wird die zweite metallische Lage in mehrere zweite Bereiche untergliedert. Die zweiten Bereiche der zweiten metallischen Lage können nach dem Untergliedern elektrisch gegeneinander isoliert sein. Das Untergliedern kann beispielsweise dadurch erfolgen, dass Gräben in die zweite metallische Schicht eingebracht werden, die bis zur ersten nichtmetallischen Schicht reichen können. Dazu können beispielsweise bekannte Maskenätzverfahren, mechanische Abtragsverfahren oder Laserabtragsverfahren eingesetzt werden. Durch das Untergliedern der zweiten metallischen Lage kann die unten definierte Montagefläche in mehrere Teilflächen zerlegt sein. Diese Teilflächen können die Oberflächen der genannten zweiten Bereiche sein.

Das erfindungsgemäße Verfahren umfasst weiterhin das Bereitstellen einer Startfläche auf der ersten metallischen Lage. Die Startfläche kann eine zusammenhängende Fläche sein. Alternativ kann auch eine nicht zusammenhängende Fläche als Startfläche vorgesehen sein, die beispielsweise durch ein Untergliedern der ersten metallischen Lage entstehen kann.

Das erfindungsgemäße Verfahren umfasst außerdem die Herstellung einer Kühlerstruktur auf der Startfläche durch selektives Schmelzen und/oder durch selektives Sintern wenigstens eines ersten Materials.

Verfahren zum selektiven Sintern bzw. zum selektiven Schmelzen sind bekannt und werden oftmals als 3D Druckverfahren bezeichnet.

Das erfindungsgemäße Verfahren umfasst weiterhin das Bereitstellen eines optischen oder optoelektronischen Bauteils, wobei das Bauteil wenigstens eine optisch gepumpte Laserscheibe oder wenigstens einen Diodenlaserbarren oder wenigstens eine Lichtemitterdiode (LED) umfassen kann. Ein optisches Bauteil kann beispielsweise eine Laserscheibe sein oder eine Laserscheibe mit einem Halteelement. Eine Laserscheibe kann beispielsweise eine Laserkristallscheibe sein. Eine Laserkristallscheibe kann beispielsweise eine Dotierung mit einem laseraktiven Material aufweisen. Eine Laserscheibe kann alternativ eine Halbleiterlaserscheibe sein, die dafür vorgesehen ist, im Betrieb optisch gepumpt zu werden. Die Laserscheibe kann beispielsweise eine Normalenrichtung -y aufweisen. Die Verstärkung der Laserstrahlung in der Laserscheibe kann in dieser Normalenrichtung sowie auch entgegengesetzt erfolgen.

Im Folgenden wird der Begriff Bauteil verwendet, wenn die Aussage sowohl für ein optisches als auch für ein optoelektronisches Bauteil gelten soll. Das Verfahren kann besonders für ein großflächiges Bauteil geeignet sein. Unter einem großflächigen Bauteil kann ein Bauteil mit einer Grundfläche von 0,5 cm² und mehr verstanden werden. Als Maß für die Grundfläche kann die Fläche einer senkrechten Projektion des Bauteils auf die xz-Ebene verstanden werden. Das erfindungsgemäße Verfahren umfasst das Befestigen des Bauteils auf einer Montagefläche, welche auf der zweiten metallischen Lage angeordnet ist. Die Montagefläche kann mehrere Teilflächen umfassen, die beim Untergliedern der zweiten metallischen Lage entstehen. Im mathematischen Sinne kann die Montagefläche eine nicht zusammenhängende Fläche sein, die aus mehreren Teilflächen besteht. Das optische bzw. optoelektronische Bauteil überdeckt mehrere zweite Bereiche der zweiten metallischen Lage. Das kann, anders ausgedrückt, bedeuten, dass das Bauteil in einem Schnitt senkrecht zur Plattenebene xz der Verbundplatte eine Längenausdehnung, gemessen parallel zur Plattenebene, hat, die so groß ist, dass mehrere zweite Bereiche der zweiten metallischen Lage überdeckt werden. Das Bauteil kann sich also in wenigstens einer Richtung (z-Richtung), die in der Ebene der Verbundplatte liegt, über mehrere zweite Bereiche der zweiten metallischen Lage erstrecken. Eine vorteilhafte Wirkung dieser Maßnahme besteht darin, dass thermomechanische Verspannungen des Bauteils reduziert werden können im Vergleich zu einer solchen Baugruppe, bei der die zweite metallische Lage nicht in Bereiche untergliedert wäre. Außerdem können Hohlstellen zwischen dem Bauteil und der Montagefläche vermieden werden, indem beispielsweise Luftblasen beim Fügen des Bauteils auf die Montagefläche entweichen können, bevor das Fügemittel erstarrt. Im Falle eines optoelektronischen Bauteils kann es außerdem vorteilhaft sein, dass einzelne Teile, beispielsweise Wärmeleitkörper, eines optoelektronischen Bauteils auf verschiedenen zweiten Bereichen der zweiten metallischen Lage montiert werden können, die elektrisch voneinander isoliert sind. Dadurch kann eine zuverlässige Kontaktierung des optoelektronischen Bauteils realisiert werden. Das Befestigen des Bauteils an der Montagefläche kann mit einem Fügemittel erfolgen. Vorteilhaft kann das Fügemittel eine hohe Wärmeleitfähigkeit aufweisen. Vorteilhaft kann ein metallisches Lot als Fügemittel verwendet werden.

Das erfindungsgemäße Verfahren sieht vor, daß das Befestigen des Bauteils nach der Herstellung der Kühlerstruktur erfolgt. Dadurch kann vermieden werden, dass das empfindliche Bauteil thermischen Belastungen, mechanischen Belastungen und/oder der Staubbelastung bei der Herstellung der Kühlstruktur ausgesetzt wird. Andererseits kann der Herstellungsprozeß der Kühlerstruktur bei einer erhöhten Temperatur erfolgen, die über der der Temperaturbeständigkeit des Bauteils liegt. Dadurch kann die Herstellung des Kühlkörpers schneller ausgeführt werden.

Die erfindungsgemäße optische oder optoelektronische Baugruppe umfasst einen Kühler und ein optisches oder optoelektronisches Bauteil. Der Kühler umfasst
a) eine Verbundplatte, wobei die Verbundplatte wenigstens eine erste nichtmetallische Lage und eine erste metallische Lage und eine zweite metallische Lage aufweist, wobei die zweite metallische Lage in mehrere zweite Bereiche gegliedert ist,
   wobei die Verbundplatte eine Startfläche auf der ersten metallischen Lage aufweist,
b) eine auf der Startfläche mit einem 3D Druckverfahren hergestellte Kühlerstruktur aus einem ersten Material, welches ein Metall umfasst,
c) eine Montagefläche für das Bauteil, welche auf der zweiten metallischen Lage angeordnet ist, wobei das Bauteil auf der Montagefläche befestigt ist und das Bauteil mehrere zweite Bereiche der zweiten metallischen Lage überdeckt.

Bei der Herstellung der Kühlerstruktur kann das erste Material in Pulverform zugeführt werden. Die Zuführung des ersten Materials kann schichtweise erfolgen. Das selektive Aufschmelzen und/oder das selektive Sintern kann schichtweise erfolgen. Selektives Schmelzen bzw. Sintern kann bedeuten, dass das erste Material nur an vorbestimmten Stellen verfestigt wird, während es an anderen Stellen nicht verfestigt wird. Das Schmelzen bzw. Sintern kann mit einem Laserstrahl vorgenommen werden. Die erste Schicht der Kühlerstruktur kann unmittelbar auf der Startfläche erzeugt werden. Das schichtweise Wachstum der Kühlerstruktur kann in einer Wachstumsrichtung y senkrecht zur Plattenebene xz erfolgen. Das heißt, dass die Schichten des Materialauftrags bzw. des Sinterns senkrecht zur Richtung y liegen. Nach oder auch schon während der Herstellung der Kühlerstruktur kann überschüssiges unverfestigtes erstes Material entfernt werden, beispielsweise durch Ausspülen des Kühlers. Das schichtweise selektive Schmelzen bzw. selektive Sintern eines in Pulverform zugeführten Materials kann ein 3D-Druckverfahren sein, welches besonders vorteilhaft ist. Alternativ können auch andere 3D-Druckverfahren zum Einsatz kommen. Beispielsweise könnte das erste Material in viskoser Form zugeführt und beispielsweise mittels eines Laserstrahls verfestigt werden.

Die erste metallische Lage kann aus Cu, Ag, Ni, Au oder Al bestehen oder einen der genannten Stoffe umfassen. Besonders vorteilhaft kann ein Material mit einer hohen Wärmeleitfähigkeit vorgesehen werden, besonders vorteilhaft kann die Verwendung von Ag oder Cu sein. Vorteilhaft kann die erste metallische Lage aus einem relativ weichen Material bestehen, beispielsweise Cu. Dadurch können mechanischen Verspannungen in der Baugruppe reduziert werden. Das erste Material kann Ag, Cu, AI, Ni, Cr, Mo, W oder ein anderes Metall sein oder eines dieser Metalle umfassen. Vorteilhaft kann die Verwendung eines Materials mit hoher Wärmeleitfähigkeit sein, beispielsweise Cu oder Ag. Dadurch kann eine hohe Effizienz der Kühlerstruktur erreicht werden. Alternativ kann auch ein Material vorteilhaft sein, welches sich besser Sintern lässt, beispielsweise Ni oder Cr. Alternativ kann auch ein Material vorteilhaft sein, welches hernach im Kühlmittelstrom langsamer abgetragen wird, beispielsweise Mo, W, Ni oder Cr. Vorteilhaft kann das erste Material eine größere Härte aufweisen als die erste metallische Lage. Dazu kann beispielsweise die Vickers-Härte herangezogen werden. Dadurch kann erreicht werden, dass die Kühlerstruktur durch den Kühlmittelstrom langsamer abgetragen wird, als wenn man als erstes Material das gleiche Material wie für die erste metallische Lage verwenden würde. Dadurch kann die Standzeit der Baugruppe erhöht werden. Die Abtragungsrate im Kühlmittelstrom kann auch dadurch reduziert werden, dass das erste Material zugeführt wird als Metallpulver, beispielsweise Cu oder Ag, dem eine bestimmte Menge Keramikpulver, beispielsweise Al₂O₃ und/oder AIN und/oder ZrO₂ (rein, teilstabilisiert oder vollstabilisiert) und/oder BN und/oder BeO beigemischt wurde. Im Falle von BN kann besonders vorteilhaft β-BN mit kubischer Kristallstruktur verwendet werden. Zum Beimischen können beispielsweise auch Diamantpulver, Siliziumcarbidpulver oder Borcarbidpulver verwendet werden. Die einzelnen Partikel des bzw. der verwendeten nichtmetallischen Pulver können eine metallische Beschichtung aufweisen, damit sie besser mit dem Metallpulver versintert werden können.

Die erste metallische Lage kann als Dickschichtmetallisierung ausgeführt sein. Durch eine dicke metallische Schicht können mechanische Verspannungen in der Baugruppe im Vergleich zu einer Dünnschichtmetallisierung reduziert werden. Vorteilhaft kann die erste metallische Lage wenigstens 50µm dick ausgeführt sein. Dadurch kann eine Rissbildung in der ersten nichtmetallischen Lage während der Herstellung der Kühlerstruktur vermieden werden.

Die erste nichtmetallische Lage kann vorteilhaft aus Al₂O₃, SiC, BeO oder AIN oder einem anderen keramischen Werkstoff oder aus Diamant bestehen oder einen der genannten Werkstoffe umfassen. Besonders vorteilhaft kann die Verwendung einer Keramik mit hoher Wärmeleitfähigkeit sein, beispielsweise BeO oder AIN. Die erste nichtmetallische Lage kann als eine Platte aus einem der genannten Materialien ausgebildet sein. In Betracht kämen weiterhin andere Materialien wie Kunststoff oder nichtmetallische Verbundwerkstoffe. Eine hohe Wärmeleitfähigkeit kann vorteilhaft sein, um die Abwärme vom Bauteil ableiten zu können. Die Dicke der ersten nichtmetallischen Lage kann beispielsweise vorteilhaft zwischen 0,2mm und 5mm betragen, beispielsweise kann eine Standarddicke von 0,25mm, 0,38mm, 0,5mm, 0,63mm, 1 mm, 2mm oder 5mm verwendet werden. Durch eine ausreichend dicke erste nichtmetallische Lage kann eine mechanische Stabilität der Verbundplatte bereitgestellt werden. Es kann aber auch eine dünne erste nichtmetallische Lage, die als elektrisch isolierende Schicht ausgebildet ist, verwendet werden. Die Dicke kann beispielsweise zwischen 1µm und 100µm liegen. Für die mechanische Stabilität der Verbundplatte kann dann eine andere Lage, beispielsweise erste oder zweite metallische Lage, mit einer für die Stabilität erforderlichen Dicke vorgesehen werden.

Das Verfahren kann ebenfalls vorteilhaft umfassen:
g) Untergliedern der ersten metallischen Lage in erste Bereiche.

Das Untergliedern kann beispielsweise dadurch erfolgen, dass Gräben in die erste metallische Schicht eingebracht werden, die bis zur ersten nichtmetallischen Schicht reichen können. Dazu können beispielsweise bekannte Maskenätzverfahren, mechanische Abtragsverfahren oder Laserabtragsverfahren eingesetzt werden. Die Kühlerstruktur kann dann vorteilhaft auf den ersten erste Bereichen der ersten metallischen Lage hergestellt werden. Das kann den Vorteil haben, dass hernach der Kühlmittelstrom direkt an der ersten nichtmetallischen Schicht entlang fließen kann. Dadurch kann ein eventueller Abtrag der ersten metallischen Schicht durch das Kühlmittel vermieden oder vermindert werden. Dadurch können die Langzeitstabilität des Strömungswiderstandes und der Wärmeübertragung des Kühlers verbessert werden. Außerdem kann die erste nichtmetallische Lage dann direkt gekühlt werden, wodurch der Wärmeübergang verbessert sein kann. Außerdem kann durch das Untergliedern der ersten metallischen Lage in erste Bereiche eine eventuelle thermomechanisch bedingte Durchbiegung der Verbundplatte beim erfindungsgemäßen Verfahren oder hernach beim Betrieb der Baugruppe vermieden oder reduziert werden.

Das Verfahren kann ebenfalls vorteilhaft umfassen:
h) oberflächliche Beschichtung der ersten und/oder der zweiten metallischen Lage mit Gold wobei Schritt h vor Schritt d erfolgt.

Die Verbundplatte kann also vergoldet sein. Die Kühlerstruktur kann dann direkt auf der oberflächlichen Goldschicht hergestellt werden. Durch die Goldschicht kann eine Oxidation der metallischen Lagen vermieden werden. Das kann insbesondere hinsichtlich der technologischen Prozesssicherheit von Vorteil sein.

Mit dem erfindungsgemäßen Verfahren kann eine erfindungsgemäße optische oder optoelektronische Baugruppe hergestellt werden. Die Baugruppe umfasst einen Kühler und ein optisches oder optoelektronisches Bauteil, wobei der Kühler umfasst
a) eine Verbundplatte, wobei die Verbundplatte wenigstens eine erste nichtmetallische Lage 11 und eine erste metallische Lage und eine zweite metallische Lage aufweist, wobei die zweite metallische Lage in mehrere zweite Bereiche gegliedert ist,
   wobei die Verbundplatte eine Startfläche auf der der ersten metallischen Lage 12 aufweist,
b) eine auf der Startfläche mit einem 3D Druckverfahren hergestellte Kühlerstruktur aus einem ersten Material, welches ein Metall umfasst,
c) eine Montagefläche für das Bauteil, welche auf der zweiten metallischen Lage angeordnet ist, wobei das Bauteil auf der Montagefläche befestigt ist und das Bauteil mehrere zweite Bereiche der zweiten metallischen Lage überdeckt.

Das optische oder optoelektronische Bauteil kann eine optisch gepumpte Laserscheibe, oder ein Diodenlaserbauteil oder ein Leuchtdioden (LED) - Bauteil sein.

Das Diodenlaserbauteil kann einen einzelnen Diodenlaserbarren umfassen. Das Diodenlaserbauteil kann außerdem zwei Wärmeleitkörper umfassen, zwischen welchen der Laserbarren angeordnet ist. Alternativ kann das Diodenlaserbauteil einen Stapel von Diodenlaserelementen und Wärmeleitkörpern umfassen. Die Diodenlaserelemente können Strahlquellen sein, die als Laserbarren ausgebildet sind. Ein Laserbarren kann in bekannter Weise als kantenemittierendes Bauteil ausgebildet sein und einen oder bevorzugt mehrere Emitter umfassen, welche in einer x-Richtung jeweils versetzt zueinander angeordnet sein können. Der Laserbarren kann bevorzugt in x-Richtung eine Breite zwischen 3 mm und 12 mm haben. Er kann bevorzugt zwischen 3 und 100 Emitter aufweisen, handelsüblich sind insbesondere Laserbarren mit 5, 7, 19 oder 49 Emittern. Der Mittenabstand benachbarter Emitter kann bevorzugt zwischen 0.1 mm und 1 mm betragen. Die Dicke des Laserbarrens kann in einer z-Richtung bevorzugt zwischen 0,05 mm und 0,2 mm betragen. Die Resonatorlänge der Emitter eines Laserbarrens in einer y-Richtung kann bevorzugt zwischen 0,5 mm und 6 mm liegen. Die Richtung der Zentralstrahlen der emittierten Laserstrahlung kann die -y Richtung sein. Die Richtungen x,y und z können rechtwinklig zueinander sein. Der Laserbarren kann eine bekannte epitaktisch hergestellte Schichtfolge als p-n-Übergang mit einem Quantengraben aufweisen. Die einzelnen Emitter können beispielsweise als Breitstreifenemitter oder als Stegwellenleiter ausgebildet sein. Es können auch mehrere Schichtfolgen mit jeweils wenigstens einem Quantengraben, d. h. mehrere elektrisch in Serie liegende p-n Übergänge vorhanden sein. Solche Barren werden auch als Nanostack bezeichnet. Dann sind mehrere Emitter in z-Richtung übereinander gestapelt.

Ein Laserbarren kann durch einen elektrischen Strom gepumpt werden. Zum Stromeintrag können eine erste elektrische Kontaktfläche und eine zweite elektrische Kontaktfläche an jedem Laserbarren vorgesehen sein.

Die Diodenlaserelemente können bezüglich des o.g. Koordinatensystems in mehreren xy Ebenen parallel angeordnet sein. Zwischen jeweils zwei Diodenlaserelementen kann wenigstens ein elektrisch leitfähiger Wärmeleitkörper angeordnet sein. Dadurch kann sichergestellt werden, dass die genannten jeweils zwei Diodenlaserelemente über den Wärmeleitkörper elektrisch verbunden sind. Der Stapel kann ein erstes und ein letztes Diodenlaserelement aufweisen. Damit sind die beiden äußeren Diodenlaserelemente des Stapels gemeint. Im Stapel können mehrere Wärmeleitkörper vorhanden sein. Dabei kann der Stapel so ausgebildet sein, dass jeder Wärmeleitkörper mit genau zwei Laserbarren verbunden ist und jeder Laserbarren, mit Ausnahme des ersten und des letzten Laserbarrens, mit genau zwei Wärmeleitkörpern verbunden ist. Die Wärmeleitkörper können vorteilhaft in z- Richtung eine Ausdehnung von 0,2 mm bis 5 mm haben. Der Stapel kann weiterhin einen ersten und einen zweiten Kontaktkörper umfassen. An dem ersten Laserbarren kann der erste Kontaktkörper angebracht sein. An dem letzten Laserbarren kann der zweite Kontaktkörper angebracht sein. Im Stapel können die Diodenlaserelemente elektrisch in Serie geschaltet sein. Der erste und der zweite Kontaktkörper können zum elektrischen Anschluß des Stapels vorgesehen sein. Der Betriebsstrom der Diodenlaserelemente kann vom ersten Kontaktkörper durch den Stapel zum zweiten Kontaktkörper fließen. Der erste Kontaktkörper kann als Anodenanschluß, der zweite Kontaktkörper als Kathodenanschluß ausgebildet sein.

Jeder Wärmeleitkörper kann eine Befestigungsfläche aufweisen. Auch die eventuell vorgesehenen Kontaktkörper können eine solche Befestigungsfläche aufweisen. Die Befestigungsflächen können in einer xz Ebene liegen. Die Befestigungsflächen benachbarter Wärmeleitkörper können einen ersten Abstand zueinander haben. Dieser erste Abstand kann in z-Richtung vorliegen. Er kann im Wesentlichen der Dicke der Diodenlaserelemente, d.h. deren Ausdehnung in z-Richtung, entsprechen. Das kann bedeuten, dass der erste Abstand auch um die Dicke von Fügemittelschichten größer sein kann als die Dicke des Diodenlaserelements. Der erste Abstand ist erforderlich, um einen Kurzschluß von Diodenlaserelementen zu vermeiden. In einer bevorzugten Ausführungsform können die Wärmeleitkörper quaderförmig sein. Die Wärmeleitkörper können beispielsweise aus Silber, Kupfer, Molybdän, oder Wolfram gefertigt sein. Sie können ebenfalls vorteilhaft aus Wolframkupfer gefertigt sei, welches pulvermetallurgisch hergestellt werden kann. Ebenfalls vorteilhaft kann es sein, die Wärmeleitkörper aus einem metallhaltigen Verbundwerkstoff herzustellen, beispielsweise Silber-Diamant, Kupfer-Diamant, Aluminium-Diamant oder einem Metall-Grafit-Verbund. Solche Materialien sind beispielsweise aus DE10 2007 051 796 A1 und EP 0 364 155 A2 bekannt. Ebenfalls kann ein metallhaltiger Werkstoff verwendet werden, der Kohlenstoff-Nanotubes enthält. Von Vorteil kann eine gute Wärmeleitfähigkeit und eine gute elektrische Leitfähigkeit des Materials sein. Die Wärmeleitkörper können oberflächlich beschichtet sein, um beispielsweise eine gute Lötbarkeit herzustellen. Beispielsweise kann eine bekannte Ni/Au Beschichtung erfolgen.

Jeder Wärmeleitkörper kann an wenigstens einem Bereich der zweiten metallischen Lage befestigt sein. Die Befestigungsfläche des jeweiligen Wärmeleitkörpers kann dazu mit einer oder mehreren Teilflächen der Montagefläche der Verbundplatte verbunden sein. Gleichermaßen können auch die Kontaktkörper an der Montagefläche befestigt sein. Mehrere der zweiten Bereiche der zweiten metallischen Lage können, wie oben beschrieben, durch Gräben voneinander getrennt sein. Die Laserbarren können in parallelen Barrenebenen xy angeordnet sein.

Mehrere benachbarte Gräben können in einem Schnitt senkrecht zur Barrenebene xy und senkrecht zur Verbundplattenebene xz einen Abstand zueinander haben, der kleiner ist, als die Dicke der Diodenlaserbarren, gemessen in z-Richtung.

Die Kühlerstruktur kann an der der Verbundplatte gegenüberliegenden Seite gegenüber der Umgebung abgeschlossen sein. Dann kann hernach im Betrieb kein Kühlmittel entweichen. Das kann von Vorteil sein, wenn ein flüssiges Kühlmittel, beispielsweise Wasser verwendet werden soll. Alternativ kann auch eine Kühlmittelstruktur von Vorteil sein, die nicht abgeschlossen ist. Im Falle einer Luftkühlung kann dann beispielswies der Kühlmittelstrom frei abströmen.

Die Kühlerstruktur kann eine innere Kühlerstruktur umfassen. Eine innere Kühlerstruktur kann dadurch gekennzeichnet sein, dass sie vom Kühlmittel umgeben ist. Die innere Kühlerstruktur kann vorteilhaft als Säulenstruktur ausgebildet sein. Die Säulen können beispielsweise zylinderförmig, kegelstumpfförmig, pyramidenstumpfförmig oder quaderförmig ausgebildet sein. Die Säulen können vorteilhaft in x- bzw. z- Richtung eine Ausdehnung von 0,2mm bis 5mm haben. Die Ausdehnung der inneren Kühlerstruktur in y Richtung kann vorteilhaft zwischen 0,2mm und 20mm betragen. Die Säulen können beispielsweise in Zeilen (z-Richtung) und Spalten (x-Richtung) regelmäßig angeordnet sein. Ebenfalls möglich ist eine Kanalstruktur als innere Kühlerstruktur. Dabei können mehrere Kanäle vorgesehen sein. Die Kanäle können jeweils durch Wände begrenzt sein. Ein Vorteil einer Säulenstruktur gegenüber einer Kanalstruktur kann darin bestehen, dass thermomechanische Verspannungen in der Baugruppe reduziert sein können. Über die innere Kühlerstruktur kann eine Haube gestülpt sein, die den Kühler nach außen begrenzt. Die Haube kann Einlaß- und Auslaßöffnungen für das Kühlmittel aufweisen. In diesem Fall können zum Herstellungsverfahren noch das Bereitstellen einer Haube, das Stülpen der Haube über die innere Kühlerstruktur und das Befestigen der Haube an der Verbundplatte notwendig sein.

Die Kühlerstruktur kann eine äußere Kühlerstruktur umfassen. Eine äußere Kühlerstruktur kann dadurch gekennzeichnet sein, dass sie nur einseitig vom Kühlmittel umgeben ist und dass sie auf der anderen Seite den Kühler gegenüber der Umwelt abschließt. Die Kühlerstruktur, welche eine innere und eine äußere Kühlerstruktur umfassen kann, kann in einem Verfahrensschritt hergestellt werden. Die äußere Kühlerstruktur kann eine gewellte Wand umfassen. Eine gewellte Wand kann gegenüber einer ebenfalls möglichen ebenen Wand den Vorteil haben, dass thermomechanische Verspannungen in der Baugruppe reduziert sein können.

Die Figuren zeigen Folgendes:
Fig. 1 zeigt eine erfindungsgemäße optische Baugruppe eines zweiten Ausführungsbeispiels in einem yz-Schnitt.
Fig. 2 zeigt eine erfindungsgemäße optoelektronische Baugruppe eines dritten Ausführungsbeispiels in einem yz-Schnitt.
Fig. 3 zeigt die erfindungsgemäße Baugruppe des dritten Ausführungsbeispiels in einem xz-Schnitt entlang einer Schnittebene AA durch die Kühlstruktur.
Fig. 4 zeigt einen Schritt eines ersten Ausführungsbeispiels des erfindungsgemäßen Verfahrens.
Fig. 5 zeigt einen weiteren Schritt des ersten Ausführungsbeispiels des erfindungsgemäßen Verfahrens.
Fig. 6 zeigt zwei fertiggestellte Kühler des ersten Ausführungsbeispiels des erfindungsgemäßen Verfahrens.
Fig. 7 zeigt eine erfindungsgemäße Baugruppe eines vierten Ausführungsbeispiels in einem xz-Schnitt entlang einer Schnittebene durch die Kühlstruktur.
Fig. 8 zeigt eine erfindungsgemäße optoelektronische Baugruppe eines fünften Ausführungsbeispiels in einem yz-Schnitt.

### Ausführungsbeispiele:

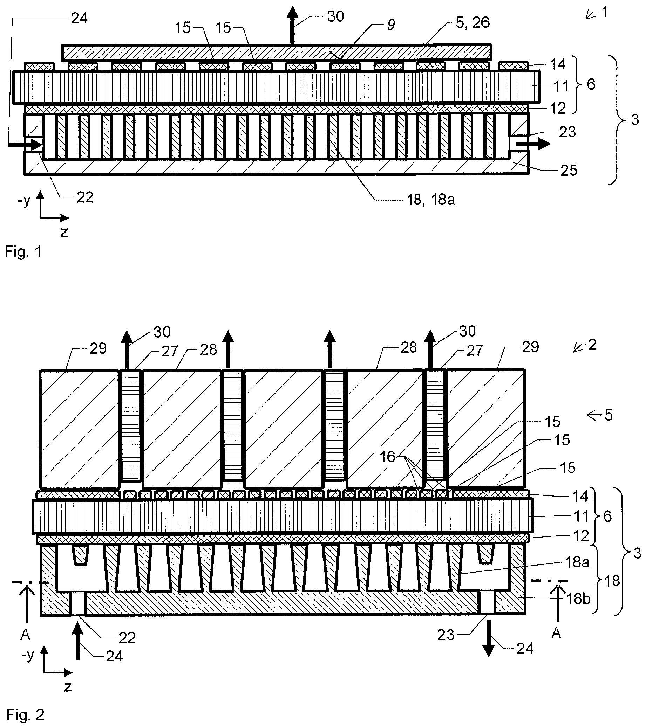

Fig. 1 zeigt ein zweites Ausführungsbeispiel einer optischen Baugruppe 1 in einem yz Schnitt. Die Baugruppe umfasst einen Kühler 3 und ein optisches Bauteil 5, welche als Laserscheibe 26 vorliegt. Im Betrieb wird eine Laserstrahlung 30 in Richtung -y emittiert. Um die Abwärme von der Laserscheibe 26 abzuführen, wird ein Kühlmittelstrom 24 verwendet. Als Kühlmittel kommt beispielsweise Wasser in Betracht. Der Kühler 3 umfasst eine Verbundplatte 6, eine Kühlerstruktur 18, die hier als innere Kühlerstruktur 18a vorliegt, sowie eine Haube 25, die den Kühlmittelstrom von der Umgebung abgrenzt. In die Haube 25 sind ein Kühlmitteleinlass 22 und ein Kühlmittelauslass 23 eingearbeitet. Die Verbundplatte 6 umfasst eine erste nichtmetallische Lage 11, eine erste metallische Lage 12 und eine zweite metallische Lage 14, die in mehrere zweite Bereiche 15 untergliedert ist. Die zweite metallische Lage 14 weist eine Montagefläche 9 auf, an welcher die Laserscheibe 26 befestigt ist. Die Laserscheibe 26 überdeckt dabei mehrere zweite Bereiche 15.

Fig. 2 zeigt ein drittes Ausführungsbeispiel einer optoelektronischen Baugruppe 2 in einem yz Schnitt. Die Baugruppe umfasst einen Kühler 3 und ein optoelektronisches Bauteil 5, welche als Diodenlaserbauteil vorliegt. Das Diodenlaserbauteil umfasst einen Stapel von Laserbarren 27 und Wärmeleitkörpern 28, der an beiden Enden mit jeweils einem Kontaktkörper 29 abgeschlossen ist. Im Betrieb wird von den Laserbarren 27 Laserstrahlung 30 in Richtung -y emittiert. Um die Abwärme abzuführen, wird ein Kühlmittelstrom 24 verwendet. Als Kühlmittel kommt beispielsweise Wasser in Betracht. Der Kühler 3 umfasst eine Verbundplatte 6, eine Kühlerstruktur 18, die hier als innere Kühlerstruktur 18a und äußere Kühlerstruktur 18b vorliegt. Die äußere Kühlerstruktur 18b grenzt den Kühlmittelstrom von der Umgebung ab. In die äußere Kühlerstruktur 18b sind ein Kühlmitteleinlass 22 und ein Kühlmittelauslass 23 eingearbeitet. Die Verbundplatte 6 umfasst eine erste nichtmetallische Lage 11, eine erste metallische Lage 12 und eine zweite metallische Lage 14, die in mehrere zweite Bereiche 15 untergliedert ist. Die zweiten Bereiche 15 sind voneinander getrennt durch Gräben 16. Die Gräben 16 verhindern, dass benachbarte Wärmeleitkörper 28 bzw. Kontaktkörper 29 über die zweite metallische Lage 14 elektrisch kurzgeschlossen würden. Das optoelektronische Bauteil 5 überdeckt mehrere zweite Bereiche 15. Weiterhin angegeben ist die Lage einer Schnittebene AA durch den Kühler 3.

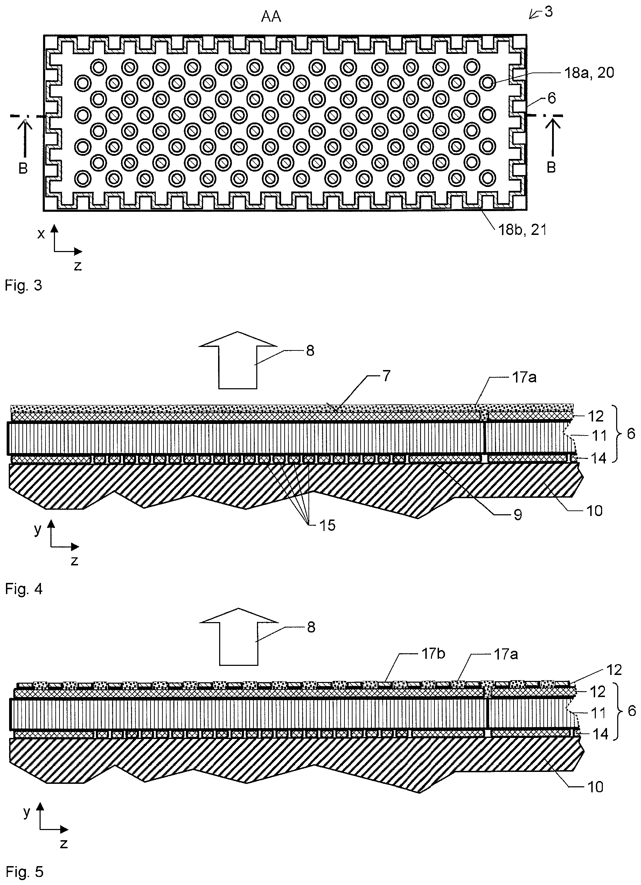

Fig. 3 zeigt die erfindungsgemäße Baugruppe des dritten Ausführungsbeispiels in einem xz-Schnitt entlang der Schnittebene AA durch den Kühler 3. Die innere Kühlerstruktur 18a ist als Säulenstruktur 20 ausgebildet. Die Säulen sind kreiskegelstumpfförmig ausgebildet. Ebenfalls dargestellt ist die äußere Kühlerstruktur 18b, die als gewellte Wand 21 ausgebildet ist.

Fig. 4 zeigt einen Schritt eines ersten Ausführungsbeispiels des erfindungsgemäßen Verfahrens. Die Verbundplatte 6 ist während der Herstellung der Kühlerstruktur mit der Montagefläche 9 auf dem Träger 10 befestigt. Die zweite metallische Lage14 ist zuvor schon in zweite Bereiche 15 untergliedert worden. Das Ausführungsbeispiel zeigt, dass mehrere Kühler gleichzeitig hergestellt werden können. Auf die Startfläche 7, die sich oben auf der ersten metallischen Lage 12 befindet wird ein erstes Material als Pulver 17a aufgetragen. Das Auftragen erfolgt in bekannter Weise als Schicht einer vorbestimmten Dicke.

Fig. 5 zeigt einen weiteren Schritt des ersten Ausführungsbeispiels des erfindungsgemäßen Verfahrens. Das erste Material 17 wird an vorbestimmten Stellen mit einem Laserstrahl gesintert oder aufgeschmolzen. Die Pulverpartikel verbinden sich dabei beim Erstarren untereinander und mit der darunter liegenden ersten metallischen Lage 12. Danach liegt an den laserbearbeiteten Stellen erstes Material in verfestigter Form 17b vor, während an den ungelaserten Stellen erstes Material als Pulver 17a verbleibt. Nun können sukzessive weitere Schichten des ersten Materials in Pulverform aufgetragen und stellenweise verfestigt werden. Dadurch kann die Kühlerstruktur in einer Wachstumsrichtung 8 schichtweise hergestellt werden.

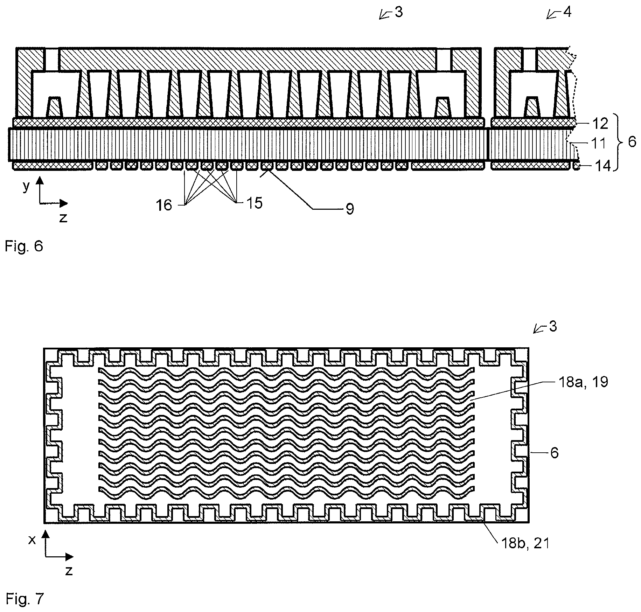

Fig. 6 zeigt zwei fertiggestellte Kühler des ersten Ausführungsbeispiels des erfindungsgemäßen Verfahrens. Neben dem Kühler 3 ist ein weiterer Kühler 4 im gleichen Arbeitsgang hergestellt worden. Man kann eine entsprechend große Verbundplatte 6 (auch als Nutzen zu bezeichnen) bereitstellen, um eine große Zahl von Kühlern gleichzeitig herzustellen. Diese werden hernach vereinzelt, indem man die erste nichtmetallische Lage 11 an vorbestimmten Stellen zwischen den einzelnen Kühlern durchtrennt. Auch ist es möglich, nicht nur die Kühler, sondern die gesamte Baugruppe im Nutzen herzustellen und die Baugruppen erst nach der Befestigung der Bauteile zu vereinzeln. In Fig. 6 ist auch die Trennung der zweiten Bereiche 15 durch Gräben 16 zu erkennen. Dadurch ist auch die Montagefläche 9 in Teilflächen aufgeteilt. Im mathematischen Sinne ist die Montagefläche keine zusammenhängende Fläche.

Fig. 7 zeigt eine erfindungsgemäße Baugruppe eines vierten Ausführungsbeispiels in einem xz-Schnitt entlang einer Schnittebene durch die Kühlstruktur. Hier umfasst die innere Kühlerstruktur 18a mehrere Kühlkanäle 19, die durch gewellte Wände begrenzt sind

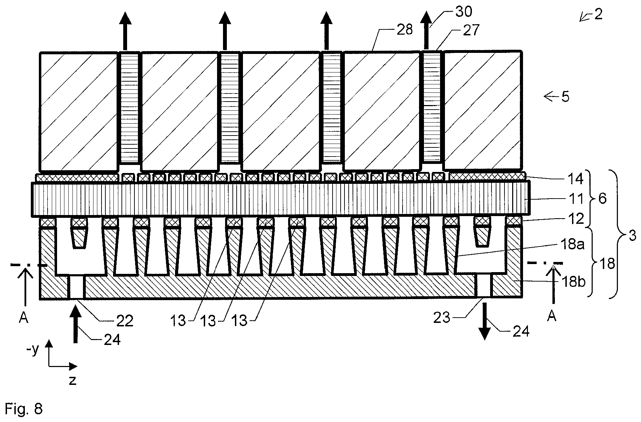

Fig. 8 zeigt eine erfindungsgemäße optoelektronische Baugruppe eines fünften Ausführungsbeispiels in einem yz-Schnitt. Die erste metallische Lage 12 ist in erste Bereiche 13 untergliedert. Dadurch kann das Kühlmittel stellenweise an der ersten nichtmetallischen Lage 11 entlang strömen.

Der Vollständigkeit halber sei darauf hingewiesen, dass die Figuren nicht maßstäblich gezeichnet sind. Der Schutzbereich des europäischen Patents wird durch die Patentansprüche bestimmt.

### Bezugszeichen:

- 1: optische Baugruppe
- 2: optoelektronische Baugruppe
- 3: Kühler
- 4: weiterer Kühler
- 5: Bauteil
- 6: Verbundplatte
- 7: Startfläche
- 8: Wachstumsrichtung
- 9: Montagefläche
- 10: Träger
- 11: erste nichtmetallische Lage
- 12: erste metallische Lage
- 13: erste Bereiche
- 14: zweite metallische Lage
- 15: zweite Bereiche
- 16: Gräben
- 17: erstes Material
a. erstes Material als Pulver
b. erstes Material in verfestigter Form

- 18: Kühlerstruktur
a. innere Kühlerstruktur
b. äußere Kühlerstruktur

- 19: Kühlkanäle
- 20: Säulenstruktur
- 21: gewellte Wand
- 22: Kühlmitteleinlass
- 23: Kühlmittelauslass
- 24: Kühlmittelstrom
- 25: Haube
- 26: Laserscheibe
- 27: Laserbarren
- 28: Wärmeleitkörper
- 29: Kontaktkörper
- 30: Laserstrahlung

## Patentansprüche

1. Verfahren zur Herstellung einer optischen oder optoelektronischen Baugruppe (1, 2), umfassend
a) Bereitstellen einer Verbundplatte (6), wobei die Verbundplatte wenigstens eine erste nichtmetallische Lage (11) und eine erste metallische Lage (12) und eine zweite metallische Lage (14) aufweist,
b) Untergliedern der zweiten metallischen Lage (14) in mehrere zweite Bereiche (15),
c) Bereitstellen einer Startfläche (7) auf der ersten metallischen Lage,
d) Herstellung einer Kühlerstruktur (18) auf der Startfläche (7) durch selektives Schmelzen und/oder durch selektives Sintern wenigstens eines ersten Materials (17),
e) Bereitstellen eines optischen oder optoelektronischen Bauteils (5), wobei das Bauteil wenigstens eine optisch gepumpte Laserscheibe oder wenigstens einen Diodenlaserbarren oder wenigstens eine Lichtemitterdiode (LED) umfasst,
f) Befestigen des Bauteils auf einer Montagefläche (9), welche auf der zweiten metallischen Lage angeordnet ist, wobei das Befestigen des Bauteils nach der Herstellung der Kühlerstruktur erfolgt und das Bauteil (5) mehrere zweite Bereiche (15) der zweiten metallischen Lage überdeckt.

2. Verfahren nach Anspruch 1, **dadurch gekennzeichnet, dass** bei der Herstellung der Kühlerstruktur das erste Material in Pulverform (17a) zugeführt wird und das selektive Schmelzen und/oder das selektive Sintern schichtweise in einer Wachstumsrichtung (8) erfolgt.

3. Verfahren nach einem der vorgenannten Ansprüche, **dadurch gekennzeichnet, dass** das erste Material Ag, Cu, AI, Ni, Cr, Mo, W oder ein anderes Metall ist oder eines dieser Metalle umfasst und/oder die erste metallische Lage aus Cu, Ag, Ni, Au oder Al besteht oder einen der genannten Stoffe umfasst.

4. Verfahren nach einem der vorgenannten Ansprüche, **dadurch gekennzeichnet, dass** die erste metallische Lage (12) wenigstens 50µm dick ist.

5. Verfahren nach einem der vorgenannten Ansprüche, **dadurch gekennzeichnet, dass** die erste nichtmetallische Lage aus Al₂O₃, SiC, BeO oder AIN oder einem anderen keramischen Werkstoff oder aus Diamant besteht oder dass die erste nichtmetallische Lage einen der genannten Werkstoffe umfasst.

6. Verfahren nach einem der vorgenannten Ansprüche, außerdem umfassend g) Untergliedern der ersten metallischen Lage (12) in erste Bereiche (13), wobei die Kühlerstruktur (18) auf den ersten Bereichen (13) der ersten metallischen Lage hergestellt wird.

7. Verfahren nach einem der vorgenannten Ansprüche, außerdem umfassend h) oberflächliche Beschichtung der ersten und/oder der zweiten metallischen Lage mit Gold,
wobei Schritt h vor Schritt d erfolgt.

8. Optische oder optoelektronische Baugruppe umfassend einen Kühler und ein optisches oder optoelektronisches Bauteil (5), wobei das Bauteil wenigstens eine optisch gepumpte Laserscheibe oder wenigstens einen Diodenlaserbarren oder wenigstens eine Lichtemitterdiode (LED) umfasst,
und wobei der Kühler umfasst
a) eine Verbundplatte (6), wobei die Verbundplatte wenigstens eine erste nichtmetallische Lage (11) und eine erste metallische Lage (12) und eine zweite metallische Lage (14) aufweist, wobei die zweite metallische Lage in mehrere zweite Bereiche (15) gegliedert ist,
wobei die Verbundplatte eine Startfläche (7) auf der ersten metallischen Lage (12) aufweist,
b) eine auf der Startfläche (7) mit einem 3D Druckverfahren durch selektives Schmelzen und/oder durch selektives Sintern wenigstens eines ersten Materials (17) hergestellte Kühlerstruktur (18) aus dem ersten Material, welches ein Metall umfasst,
c) eine Montagefläche (9) für das Bauteil, welche auf der zweiten metallischen Lage (14) angeordnet ist,
wobei das Bauteil auf der Montagefläche befestigt ist und das Bauteil mehrere zweite Bereiche (15) der zweiten metallischen Lage (14) überdeckt.

9. Optische oder optoelektronische Baugruppe nach Anspruch 8, wobei das optische oder optoelektronische Bauteil (5) eine optisch gepumpte Laserscheibe (26), oder ein Diodenlaserbauteil oder ein Leuchtdioden (LED) - Bauteil ist.

10. Optische oder optoelektronische Baugruppe nach Anspruch 9, **dadurch gekennzeichnet, dass** das Diodenlaserbauteil einen einzelnen Diodenlaserbarren (27) umfasst oder einen Stapel von Diodenlaserbarren (27) und Wärmeleitkörpern (28) umfasst, wobei zwischen jeweils zwei Laserbarren wenigstens ein Wärmeleitkörper angeordnet ist und jeder Wärmeleitkörper an wenigstens einem zweiten Bereich (15) befestigt ist.

11. Optische oder optoelektronische Baugruppe nach Anspruch 10, **dadurch gekennzeichnet, dass** mehrere der zweite Bereiche (15) der zweiten metallischen Lage durch Gräben (16) voneinander getrennt sind, wobei mehrere benachbarte Gräben einen Abstand zueinander haben, der kleiner ist als eine Dicke der Diodenlaserbarren (27).

12. Optische oder optoelektronische Baugruppe nach Anspruch 8 bis 10, **dadurch gekennzeichnet, dass** die Kühlerstruktur (18) an der der Verbundplatte gegenüberliegenden Seite gegenüber der Umgebung abgeschlossen ist.

13. Optische oder optoelektronische Baugruppe nach Anspruch 8 bis 12, **dadurch gekennzeichnet, dass** die Kühlerstruktur (18) eine innere Kühlerstruktur (18a) umfasst, die als Säulenstruktur (20) ausgebildet ist.

14. Optische oder optoelektronische Baugruppe nach Anspruch 8 bis 13, **dadurch gekennzeichnet, dass** die Kühlerstruktur (18) eine innere Kühlerstruktur (18a) umfasst, über die eine Haube (25) gestülpt ist, die den Kühler nach außen begrenzt.

15. Optische oder optoelektronische Baugruppe nach Anspruch 8 bis 13, **dadurch gekennzeichnet, dass** die Kühlerstruktur (18) eine äußere Kühlerstruktur (18b) umfasst, die als gewellte Wand (21) ausgebildet ist.

## Claims

1. Method for producing an optical or optoelectronic assembly (1, 2), comprising
a) providing a composite plate (6), wherein the composite plate comprises at least one first nonmetallic layer (11) and a first metallic layer (12) and a second metallic layer (14),
b) subdividing the second metallic layer (14) into a plurality of second regions (15),
c) providing a start surface (7) on the first metallic layer,
d) producing a cooler structure (18) on the start surface (7) by selectively melting and/or by selectively sintering at least one first material (17),
e) providing an optical or optoelectronic component (5), wherein the component comprises at least one optically pumped laser disc or at least one diode laser bar or at least one light emitting diode (LED),
f) securing the component on a mounting surface (9) arranged on the second metallic layer, wherein securing the component is carried out after producing the cooler structure and the component (5) covers a plurality of second regions (15) of the second metallic layer.

2. Method according to Claim 1, **characterized in that** producing the cooler structure involves supplying the first material in powder form (17a) and carrying out the selective melting and/or the selective sintering layer by layer in a growth direction (8).

3. Method according to either of the preceding claims, **characterized in that** the first material is Ag, Cu, Al, Ni, Cr, Mo, W or some other metal or comprises one of these metals and/or the first metallic layer consists of Cu, Ag, Ni, Au or Al or comprises one of the substances mentioned.

4. Method according to any of the preceding claims, **characterized in that** the first metallic layer (12) is at least 50 µm thick.

5. Method according to any of the preceding claims, **characterized in that** the first nonmetallic layer consists of Al₂O₃, SiC, BeO or AlN or some other ceramic material or diamond or **in that** the first nonmetallic layer comprises one of the materials mentioned.

6. Method according to any of the preceding claims, additionally comprising
g) subdividing the first metallic layer (12) into first regions (13), wherein the cooler structure (18) is produced on the first regions (13) of the first metallic layer.

7. Method according to any of the preceding claims, additionally comprising
h) superficially coating the first and/or the second metallic layer with gold,
wherein step h is carried out before step d.

8. Optical or optoelectronic assembly comprising a cooler and an optical or optoelectronic component (5), wherein the component comprises at least one optically pumped laser disc or at least one diode laser bar or at least one light emitting diode (LED),
and wherein the cooler comprises
a) a composite plate (6), wherein the composite plate comprises at least one first nonmetallic layer (11) and a first metallic layer (12) and a second metallic layer (14), wherein the second metallic layer is subdivided into a plurality of second regions (15),
wherein the composite plate comprises a start surface (7) on the first metallic layer (12),
b) a cooler structure (18) produced on the start surface (7) using a 3D printing method by selectively melting and/or by selectively sintering at least one first material (17) and composed of the first material comprising a metal,
c) a mounting surface (9) for the component, said mounting surface being arranged on the second metallic layer (14),
wherein the component is secured on the mounting surface and the component covers a plurality of second regions (15) of the second metallic layer (14) .

9. Optical or optoelectronic assembly according to Claim 8, wherein the optical or optoelectronic component (5) is an optically pumped laser disc (26), or a diode laser component or a light emitting diode (LED) component.

10. Optical or optoelectronic assembly according to Claim 9, **characterized in that** the diode laser component comprises a single diode laser bar (27) or comprises a stack of diode laser bars (27) and heat-conducting bodies (28), wherein at least one heat-conducting body is arranged respectively between two laser bars, and each heat-conducting body is secured to at least one second region (15).

11. Optical or optoelectronic assembly according to Claim 10, **characterized in that** a plurality of the second regions (15) of the second metallic layer are separated from one another by trenches (16), wherein a plurality of adjacent trenches are at a distance from one another which is less than a thickness of the diode laser bars (27).

12. Optical or optoelectronic assembly according to Claims 8 to 10, **characterized in that** the cooler structure (18) is closed off from the surroundings at the opposite side relative to the composite plate.

13. Optical or optoelectronic assembly according to Claims 8 to 12, **characterized in that** the cooler structure (18) comprises an inner cooler structure (18a) configured as a columnar structure (20).

14. Optical or optoelectronic assembly according to Claims 8 to 13, **characterized in that** the cooler structure (18) comprises an inner cooler structure (18a), over which a hood (25) is slipped, which outwardly delimits the cooler.

15. Optical or optoelectronic assembly according to Claims 8 to 13, **characterized in that** the cooler structure (18) comprises an outer cooler structure (18b) configured as an undulatory wall (21).

## Revendications

1. Procédé de fabrication d'un ensemble optique ou optoélectronique (1, 2), comprenant
a) la fourniture d'une plaque composite (6), dans lequel la plaque composite comprend au moins une première couche non métallique (11) et une première couche métallique (12) et une deuxième couche métallique (14),
b) la subdivision de la deuxième couche métallique (14) en plusieurs deuxièmes zones (15),
c) la réalisation d'une surface de départ (7) sur la première couche métallique,
d) la fabrication d'une structure de dissipation thermique (18) sur la surface de départ (7) par fusion sélective et/ou par frittage sélectif d'au moins un premier matériau (17),
e) la fourniture d'un composant optique ou optoélectronique (5), dans lequel le composant comprend au moins un disque laser pompé optiquement ou au moins une barre de diodes laser ou au moins une diode électroluminescente (LED),
f) la fixation du composant sur une surface de montage (9) qui est agencée sur la deuxième couche métallique, dans lequel la fixation du composant est effectuée après la fabrication de la structure de dissipation thermique et le composant (5) recouvre plusieurs deuxièmes zones (15) de la deuxième couche métallique.

2. Procédé selon la revendication 1, **caractérisé en ce que**, lors de la fabrication de la structure de dissipation thermique, le premier matériau est délivré sous forme de poudre (17a) et **en ce que** la fusion sélective et/ou le frittage sélectif sont effectués couche par couche dans une direction de croissance (8).

3. Procédé selon l'une quelconque des revendications précédentes, **caractérisé en ce que** le premier matériau est l'Ag, le Cu, l'Al, le Ni, le Cr, le Mo, le W ou un autre métal ou comprend l'un de ces métaux et/ou **en ce que** la première couche métallique est constituée de Cu, d'Ag, de Ni, d'Au ou d'Al ou comprend l'un desdits matériaux.

4. Procédé selon l'une quelconque des revendications précédentes, **caractérisé en ce que** la première couche métallique (12) a une épaisseur d'au moins 50µm.

5. Procédé selon l'une quelconque des revendications précédentes, **caractérisé en ce que** la première couche non métallique est constituée d'Al₂O₃, de SiC, de BeO ou d'AlN ou d'un autre matériau céramique ou de diamant, ou **en ce que** la première couche non métallique comprend l'un desdits matériaux.

6. Procédé selon l'une quelconque des revendications précédentes, comprenant en outre
g) la subdivision de la première couche métallique (12) en des premières zones (13), dans lequel la structure de dissipation thermique (18) est fabriquée sur les premières zones (13) de la première couche métallique.

7. Procédé selon l'une quelconque des revendications précédentes, comprenant en outre
h) l'application d'un revêtement superficiel d'or sur la première et/ou la deuxième couche métallique,
dans lequel l'étape h est effectuée avant l'étape d.

8. Ensemble optique ou optoélectronique comprenant un dissipateur thermique et un composant optique ou optoélectronique (5), dans lequel le composant comprend au moins un disque laser pompé optiquement ou au moins une barre de diodes laser ou au moins une diode électroluminescente (LED),
et dans lequel le dissipateur thermique comprend
a) une plaque composite (6), dans lequel la plaque composite comporte au moins une première couche non métallique (11) et une première couche métallique (12) et une deuxième couche métallique (14), dans lequel la deuxième couche métallique est subdivisée en plusieurs deuxièmes zones (15),
dans lequel la plaque composite présente une surface de départ (7) sur la première couche métallique (12),
b) une structure de dissipation thermique (18) fabriquée sur la surface de départ (7) par un procédé d'impression 3D par fusion sélective et/ou par frittage sélectif d'au moins un premier matériau (17) à partir du premier matériau, qui comprend un métal,
c) une surface de montage (9) destinée au composant, qui est agencée sur la deuxième couche métallique (14), dans lequel le composant est fixé sur la surface de montage et le composant recouvre plusieurs deuxièmes zones (15) de la deuxième couche métallique (14).

9. Ensemble optique ou optoélectronique selon la revendication 8, dans lequel le composant optique ou optoélectronique (5) est un disque laser pompé optiquement (26), ou un composant à diodes laser ou un composant à diodes électroluminescentes (LED).

10. Ensemble optique ou optoélectronique selon la revendication 9, **caractérisé en ce que** le composant à diodes laser comprend une seule barre de diodes laser (27) ou comprend un empilement de barres de diodes laser (27) et de corps thermiquement conducteurs (28), dans lequel au moins un corps thermiquement conducteur est agencé entre deux barres laser respectives, et chaque corps thermiquement conducteur est fixé à au moins une deuxième zone (15).

11. Ensemble optique ou optoélectronique selon la revendication 10, **caractérisé en ce que** plusieurs des deuxièmes zones (15) de la deuxième couche métallique sont séparées les unes des autres par des tranchées (16), dans lequel plusieurs tranchées adjacentes sont espacées d'une distance inférieure à une épaisseur des barres de diodes laser (27).

12. Ensemble optique ou optoélectronique selon les revendications 8 à 10, **caractérisé en ce que** la structure de dissipation thermique (18) est fermée par rapport à l'environnement sur le côté opposé à la plaque composite.

13. Ensemble optique ou optoélectronique selon les revendications 8 à 12, **caractérisé en ce que** la structure de dissipation thermique (18) comprend une structure de dissipation thermique interne (18a) qui est réalisée sous la forme d'une structure en colonne (20).

14. Ensemble optique ou optoélectronique selon les revendications 8 à 13, **caractérisé en ce que** la structure de dissipation thermique (18) comprend une structure de dissipation thermique interne (18a) sur laquelle est rabattu un capot (25) qui délimite le dissipateur thermique vers l'extérieur.

15. Ensemble optique ou optoélectronique selon les revendications 8 à 13, **caractérisé en ce que** la structure de dissipation thermique (18) comprend une structure de dissipation thermique extérieure (18b) qui est réalisée sous forme de paroi ondulée (21).
